# FASCICULE DE BREVET EUROPEEN

(11) **EP 2 045 837 B1**
(45) Date de publication et mention de la délivrance du brevet: **09.03.2011**
(21) Numéro de dépôt: 08354062.5
(22) Date de dépôt: 24.09.2008
(51) Int. Cl.: H01L 21/336

(54) **Formation sélective d'un composé comprenant un matériau semi-conducteur et un matériau métallique dan un substrat, à travers une couche d'oxyde de germanium**
Selektive Bildung einer Verbindung, die ein Halbleitermaterial und ein Metallmaterial in einem Substrat enthält, mit Hilfe einer Germaniumoxydschicht
Selective formation of a compound comprising a semiconductor material and a metal material in a substrate, through a layer of germanium oxide

(30) Priorité: 02.10.2007 FR 0706902
(43) Date de publication de la demande: 08.04.2009
(73) Titulaire: Commissariat à l'Énergie Atomique et aux Énergies Alternatives, 75015 Paris (FR)
(72) Inventeur: Nemouchi, Fabrice, 38430 Moirans (FR)
(74) Mandataire: Hecké, Gérard

(56) Documents cités:
- US-A1- 2005 215 055
- US-B1- 6 399 467
- US-B1- 6 872 610

## Description

### Domaine technique de l'invention

L'invention concerne un procédé de fabrication d'un composant électronique.

### État de la technique

Dans l'industrie microélectronique et, en particulier dans les procédés impliquant des transistors MOS (« Metal-Oxide Semiconductor » ou métal-oxyde semiconducteur) ou CMOS (« Complementary Metal-Oxide Semiconductor » ou métal-oxyde semiconduteur complémentaire), l'étape de siliciuration, c'est-à-dire la métallisation des contacts source/drain et grille est une des étapes les plus critiques.

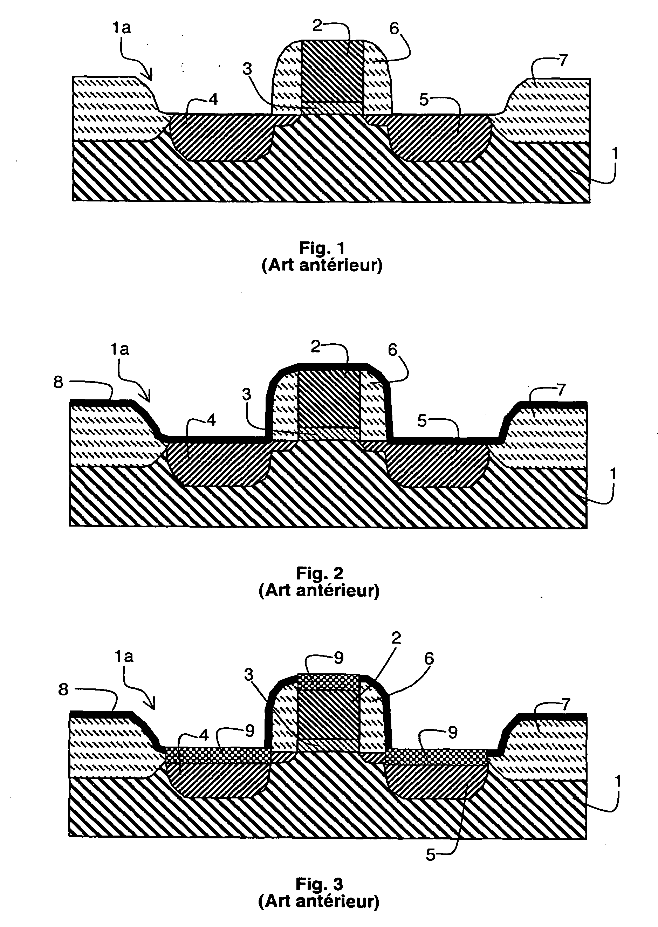

Actuellement, la technique la plus couramment utilisée pour réaliser cette métallisation est connue sous le nom de procédé « salicide » (ou procédé « Self-ALlgned siliCIDE »). Cette technique consiste, comme représentée sur les figures 1 à 5, à former un siliciure dit auto-aligné dans la source, la grille et le drain d'un substrat en silicium. Ainsi, sur la figure 1, un substrat 1 en silicium comporte, dans une surface 1 a :
- une grille 2 en silicium polycristallin, disposée sur une couche d'oxyde 3
- et une source 4 et un drain 5, séparés de la grille 2 par des cales d'espacement 6 également appelées espaceurs.
De plus, des oxydes de champ 7 permettent d'isoler la source 4 et le drain 5.

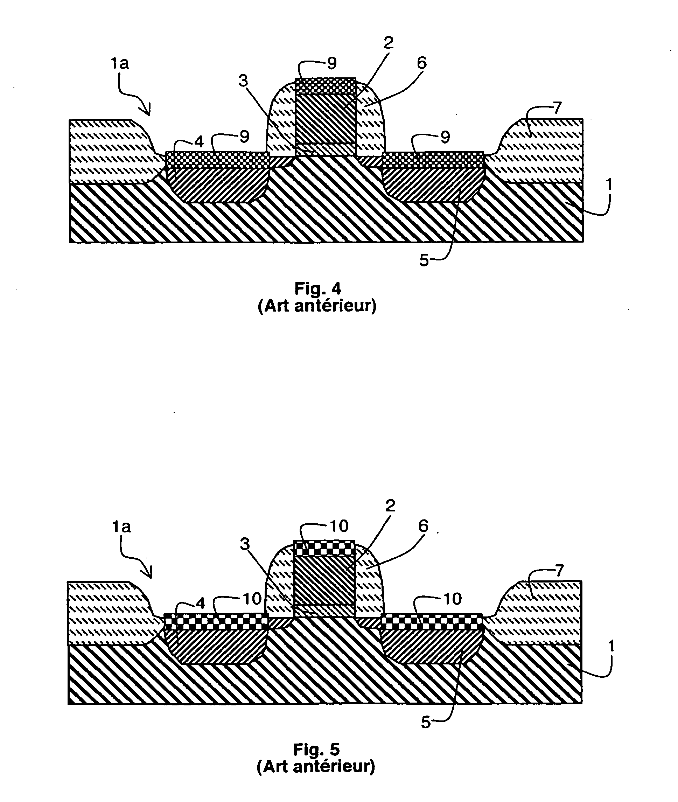

Pour réaliser le procédé « salicide », une couche métallique 8 est déposée sur la totalité de la surface 1a du substrat 1, préalablement nettoyée dans une solution d'acide fluorhydrique (HF). Sur la figure 2, la couche métallique 8, par exemple en titane, en cobalt, en nickel ou en platine, recouvre, ainsi, l'oxyde de champ 7, la source 4 et le drain 5, la grille 2 et les espaceurs 6. Un traitement thermique est, ensuite, réalisé à une température comprise entre 300°C et 500°C, dans une atmosphère contrôlée, par exemple sous vide ou de gaz neutres. Ce traitement thermique provoque la réaction entre le métal de la couche 8 et le silicium sous-jacent, c'est-à-dire le silicium de la grille 2 et le silicium de la source 4 et du drain 5. Ainsi, sur la figure 3, un composé de silicium et de métal, également appelé siliciure métallique 9, est formé dans la grille 2 et dans la source 4 et le drain 5. Par contre, les zones de la couche 8, en contact avec l'oxyde de champ 7 et les espaceurs 6, n'ont pas réagi lors du traitement thermique. Ces zones sont, ensuite, éliminées comme représenté sur la figure 4. Un éventuel traitement ou recuit thermique supplémentaire peut, ensuite, être réalisé, comme représenté sur la figure 5, pour modifier la phase cristalline du siliciure et obtenir un siliciure 10 ayant une résistance plus faible que le siliciure 9 préalablement obtenu.

Le procédé « salicide » permet, ainsi, de métalliser les contacts source/drain et grille. Cependant, le siliciure 10 obtenu avec ce procédé présente l'inconvénient d'avoir la même épaisseur à la fois dans la grille 2 et dans la source 4 et le drain 5.

Or, il peut être préférable d'obtenir une grille 2 totalement siliciurée, tandis que le siliciure 10 dans la source 4 et le drain 5 doit, au contraire, être le plus fin possible, pour éviter les problèmes de fuites de jonction.

La demande de brevet US-A-2007/0099408 décrit un procédé permettant d'obtenir des zones en siliciure d'épaisseurs différentes et d'obtenir, plus particulièrement, une grille totalement siliciurée et une fine couche de siliciure dans la source et le drain. Le procédé consiste à implanter, avant l'étape de métallisation, de l'antimoine ou de l'aluminium dans la partie supérieure de la source et du drain, de manière à freiner la formation de siliciure et donc limiter l'épaisseur du siliciure dans la source et le drain. De plus, pendant l'opération d'implantation d'antimoine ou d'aluminium, la grille est recouverte d'une couche de protection empêchant l'implantation d'antimoine ou d'aluminium dans la grille.

Un tel procédé est, cependant, délicat à mettre en oeuvre. En effet, les éléments utilisés pour l'implantation dans la source et le drain sont limités. Seuls l'aluminium et l'antimoine ont un effet sur les cinétiques de croissance des siliciures. De plus, il est nécessaire de choisir l'élément à implanter parmi l'aluminium et l'antimoine selon le type de transistor à réaliser. Un transistor pMOS nécessite l'emploi d'aluminium tandis qu'un transistor nMOS nécessite l'emploi d'antimoine. Par ailleurs, la quantité d'aluminium ou d'antimoine à implanter est au maximum de 5.10¹⁵ atomes/cm³.

Le document US-B1-6 399 467 divulgue un procédé de formation du siliciure sur la grille d'un transistor. Pendant la formation du siliciure le drain et la source sont protégés par une couche d'oxyde.

### Objet de l'invention

L'invention a pour but un procédé de fabrication d'un composant électronique permettant de remédier aux inconvénients mentionnés ci-dessus.

Selon l'invention, ce but est atteint par les revendications annexées et plus particulièrement par le fait que le procédé comporte au moins une étape de formation sélective d'au moins une zone en un composé comprenant un matériau semi-conducteur et un matériau métallique, dans un substrat en matériau semi-conducteur, ladite étape comportant au moins successivement :
- la formation d'une couche en oxyde de germanium, d'une épaisseur comprise entre 3nm et 5nm, sur une partie d'une surface du substrat et d'une couche en oxyde de silicium sur le reste de ladite surface,
- le dépôt, sur les couches d'oxyde, d'une couche constituée par un matériau métallique, dont l'oxyde est plus stable thermodynamiquement que l'oxyde de germanium et moins stable que l'oxyde de silicium,
- le recuit thermique à une température prédéterminée pour obtenir, au niveau de ladite partie de la surface du substrat, la réduction de l'oxyde de germanium par ledit matériau métallique, puis la formation de ladite zone,
- et le retrait de la couche en matériau métallique.

Selon un développement de l'invention, le matériau semi-conducteur est choisi parmi le silicium, le germanium ou un alliage de silicium et de germanium.

Selon un mode de réalisation préférentiel, un transistor comportant une grille, une source et un drain étant formé dans le substrat, la formation sélective de ladite zone est réalisée dans la grille du transistor. De plus, le retrait de la couche en matériau métallique est, avantageusement, suivi d'une étape de désoxydation de la grille, de la source et du drain et l'étape de formation sélective de ladite zone dans la grille est, plus particulièrement, suivie d'une étape de formation non sélective dudit composé dans la source, le drain et la grille. Ceci permet d'obtenir une grille totalement constituée par ledit composé et, d'obtenir, plus particulièrement, une grille totalement siliciurée (c'est-à-dire en siliciure métallique) dans le cas d'un substrat en silicium ou en germaniure métallique dans le cas d'un substrat en germanium.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 5 représentent, schématiquement et en coupe, différentes étapes de formation d'un siliciure dans un transistor, selon l'art antérieur.
- les figures 6 à 13 représentent, schématiquement et en coupe, différentes étapes de formation d'un siliciure dans un transistor, selon l'invention.

### Description de modes particuliers de réalisation

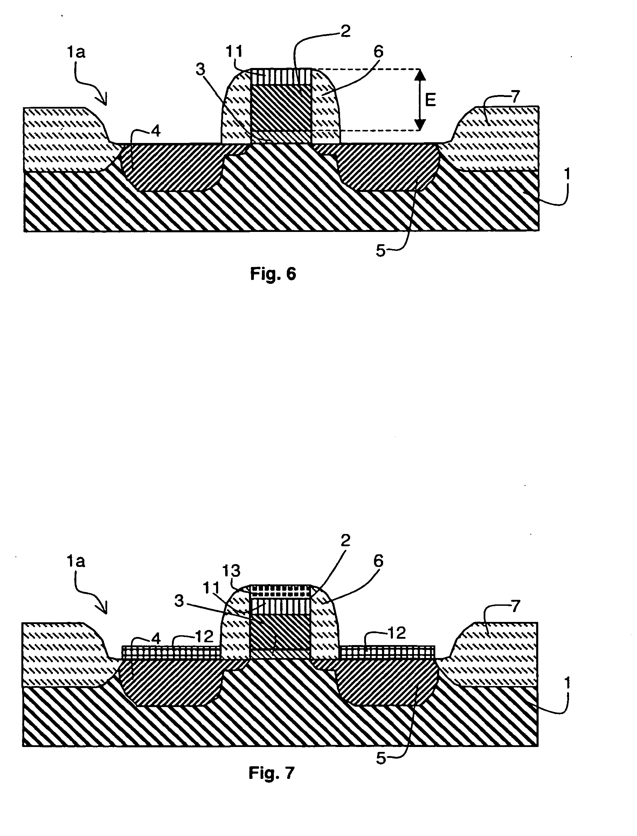

Pour obtenir un siliciure dans la grille 2 d'une épaisseur supérieure à celle du siliciure présent dans la source 4 et le drain 5, un mode particulier de réalisation de l'invention représenté schématiquement sur les figures 6 à 13 propose une autre voie que celle proposée dans la demande de brevet US-A-2007/0099408.

Cette voie consiste à former, préalablement et de manière sélective, une première couche en siliciure, d'une épaisseur e1 prédéterminée, dans la grille 2 uniquement, puis à réaliser un procédé « salicide » classique. Le procédé « salicide » permet, alors, de former, une seconde couche en siliciure d'une épaisseur e2 prédéterminée, à la fois dans la source 4 et le drain 5 et dans la grille 2. Ainsi, dans la grille 2, la seconde couche en siliciure d'épaisseur e2 complète la première couche en siliciure d'épaisseur e1. Les conditions de formation du siliciure peuvent être, avantageusement, choisies pour obtenir une grille 2 totalement siliciurée, c'est-à-dire un siliciure dont l'épaisseur totale, c'est-à-dire la somme des épaisseurs e1 et e2, correspond à la consommation totale de la grille 2 initiale d'une épaisseur initiale E. La métallisation complète d'une couche en silicium conduit, en effet, à une couche en siliciure métallique ayant une épaisseur plus importante que celle de la couche en silicium initiale, car les densités et donc les structures cristallines du siliciure métallique et du silicium sont différentes. Ainsi, à titre d'exemple, la métallisation complète d'une couche de 1,81 nm de silicium par un procédé « salicide » utilisant une couche de 1 nm d'épaisseur de nickel permet d'obtenir une couche mince en siliciure NiSi de 2,18nm.

Pour réaliser l'étape de formation sélective du siliciure dans la grille 2 et comme représenté sur la figure 6, une couche en germanium 11 est formée sur la surface libre de la grille 2 et elle est entourée par les cales d'espacement 6. La couche en germanium 11 est, en particulier, réalisée pendant la formation de la grille 2, avant que ne soient réalisées les cales d'espacement 6, la source 4 et le drain 5. Ainsi, une couche d'oxyde, une couche de silicium polycristallin et une couche en germanium sont successivement disposées sur la totalité de la surface libre du substrat 1 (dépôt pleine plaque). L'ensemble des couches est ensuite lithographié et gravé pour former la grille et donc pour conserver uniquement l'empilement de grille (3, 2 et 11 sur la figure 6). L'épaisseur de la couche en germanium 11 disposée sur la grille 2 est, avantageusement comprise entre 4nm et 10nm.

L'ensemble de la surface 1a du substrat 1 est, ensuite, oxydée, par exemple par oxydation thermique. Ainsi, sur la figure 7, la source 4 et le drain 5 sont recouverts d'une couche en oxyde de silicium 12, tandis qu'une couche en oxyde de germanium 13 ayant une épaisseur comprise entre 3nm et 5nm recouvre la grille 2. L'oxydation de la couche en germanium 11 peut être partielle ou totale. Ainsi, une partie de la couche en germanium 11 n'ayant pas été oxydée peut être, comme représenté sur la figure 7, disposée entre la couche d'oxyde de germanium 13 et la grille 2. Dans une variante de réalisation, si toute la couche en germanium 11 a été oxydée, la couche en oxyde de germanium 13 est directement en contact avec la grille 2. Dans ce cas, les conditions de l'étape d'oxydation doivent, cependant, être maîtrisées de manière à ce que le silicium de la grille 2 ne s'oxyde pas.

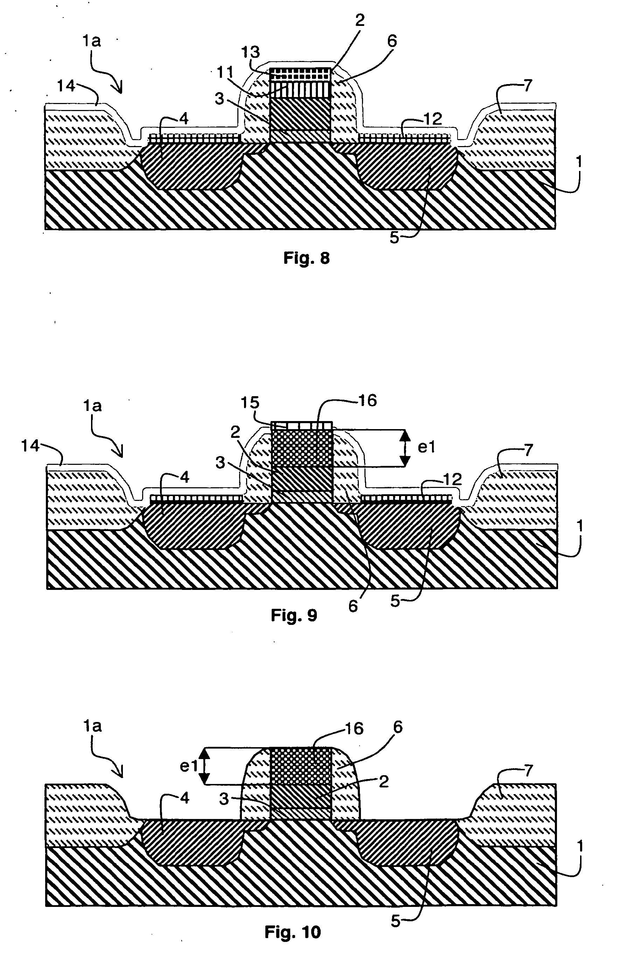

Une couche métallique 14 est ensuite déposée sur la totalité de la surface 1 a du substrat 1. Sur la figure 8, la couche métallique 14 recouvre, ainsi, les oxydes de champ 7, l'oxyde de silicium 12 formé sur la source 4 et le drain 5, l'oxyde de germanium 13 et les espaceurs 6.

Le matériau constituant ladite couche métallique 14 est choisi de manière prédéterminée, avantageusement parmi un métal ou un alliage métallique.

Le matériau métallique constituant ladite couche 14 est choisi, de sorte qu'une fois le matériau métallique oxydé, l'oxyde métallique formé correspondant soit plus stable thermodynamiquement que l'oxyde de germanium 13 et moins stable thermodynamiquement que l'oxyde de silicium 12. Ainsi, dans une gamme de températures donnée, l'oxyde de germanium sera réduit par le matériau métallique de la couche 14, de manière à obtenir l'oxyde métallique correspondant tandis que l'oxyde de silicium ne sera pas réduit par le matériau métallique.

De plus, le choix du matériau constituant la couche métallique 14 peut être déterminé en fonction du matériau semi-conducteur sous-jacent, c'est-à-dire le matériau semi-conducteur de la grille 2, avec lequel le matériau métallique doit réagir, mais aussi en fonction des propriétés électriques et thermocinétiques du composé du matériau métallique et du matériau semi-conducteur ainsi formé. Ainsi, dans le mode de réalisation représenté sur les figures 6 à 13, la grille 2 étant en silicium, le matériau métallique formant la couche métallique 14 est choisi de manière à réagir avec ledit silicium pour former un siliciure. Pour une grille en germanium, le matériau métallique de la couche métallique 14 est choisi pour former un germaniure métallique, c'est-à-dire un composé, de préférence défini, de germanium et dudit matériau.

Avantageusement, le matériau constituant la couche métallique 14 peut être choisi parmi le chrome, le cobalt, le nickel, le cuivre, un alliage nickel-platine (également noté Ni(Pt)) ou un alliage nickel-titane (également noté Ni(Ti)), en fonction du matériau semi-conducteur formant la grille 2. Ainsi, pour une grille en silicium ou en germanium, l'ensemble des matériaux cités ci-dessus peut être utilisé pour former la couche métallique 14 tandis que pour une grille en SiGe, le matériau est, de préférence, choisi parmi le cuivre, Ni(Pt)) ou Ni(Ti).

Un recuit ou traitement thermique est, ensuite, réalisé à une température prédéterminée pour provoquer, au niveau de la grille 2, les réactions en chaîne suivantes :
(i) réduction de l'oxyde de germanium 13 par le matériau de la couche métallique 14,
(ii) et formation d'un composé, de préférence défini, entre le matériau de la couche métallique 14 et le matériau semi-conducteur sous-jacent, par diffusion réactive à travers l'oxyde métallique obtenu lors de la réaction de réduction en (i).
Plus précisément, le recuit thermique est, avantageusement, réalisé entre 300°C et 800°C, selon le matériau de la couche métallique 14 utilisé. À titre d'exemple, pour une couche métallique 14 en nickel ou en chrome, la température de recuit est avantageusement de l'ordre de 350°C tandis que la température de recuit est, de préférence, de l'ordre de 600°C pour une couche métallique 14 en cobalt et de l'ordre de 700°C pour une couche métallique 14 en cuivre. De plus, l'épaisseur de la couche métallique 14 déposée préalablement au recuit thermique est, avantageusement, supérieure à une épaisseur prédéterminée, correspondant à l'épaisseur minimale nécessaire pour réduire totalement l'oxyde de germanium 13 pendant ledit recuit. L'épaisseur de la couche métallique 14 est, plus particulièrement, déterminée par l'épaisseur e1 souhaitée pour le composé (par exemple le siliciure ou le germaniure) formé dans la grille 2.

Ainsi, dans l'exemple représenté aux figures 6 à 13, pendant le recuit thermique, le matériau de la couche métallique 14 réduit, au niveau de la grille 2, l'oxyde de germanium 13 pour former un oxyde métallique qui réagit, ensuite, avec le silicium de la grille 2 pour former un siliciure 16 d'une épaisseur e1 prédéterminée. Sur la figure 9, l'oxyde métallique n'a pas totalement réagi avec le silicium de la grille 2, de sorte que le siliciure 16 formé dans la grille 2 est encore recouvert d'une fine couche d'oxyde métallique 15 résultante. Par contre, comme l'oxyde de silicium 12 disposé sur la source 4 et le drain 5 est plus stable thermodynamiquement que ledit oxyde métallique, le matériau de la couche métallique 14 ne réduit pas l'oxyde de silicium 12 lors du recuit thermique. La source 4 et le drain 5 ne sont donc pas siliciurés pendant le traitement thermique car l'oxyde de silicium inhibe la réaction entre le matériau de la couche métallique 14 et le silicium, au niveau de la source 4 et du drain 5. Ainsi, sur la figure 9, seule la partie de la couche 14 disposée sur la grille 2 a été consommée lors du recuit thermique et le reste de la surface 1a du substrat est encore recouvert par la couche 14.

Comme représenté sur la figure 10, les parties restantes de la couche 14, disposées sur l'oxyde de silicium 12, sont, ensuite, retirées et la surface 1 a du substrat 1 est désoxydée pour supprimer l'oxyde métallique résultant 15 et pour libérer la surface de la grille 2, en partie siliciurée sur une épaisseur e1.

L'emploi d'un oxyde de germanium au niveau de la grille 2, comme couche sacrificielle, alors que le reste du substrat 1 est recouvert d'oxyde de silicium permet, grâce au choix particulier du matériau employé pour former la couche 14, de former sélectivement, dans ladite grille 2, un siliciure tandis que le drain 5 et la source 4 sont protégés par l'oxyde de silicium 12.

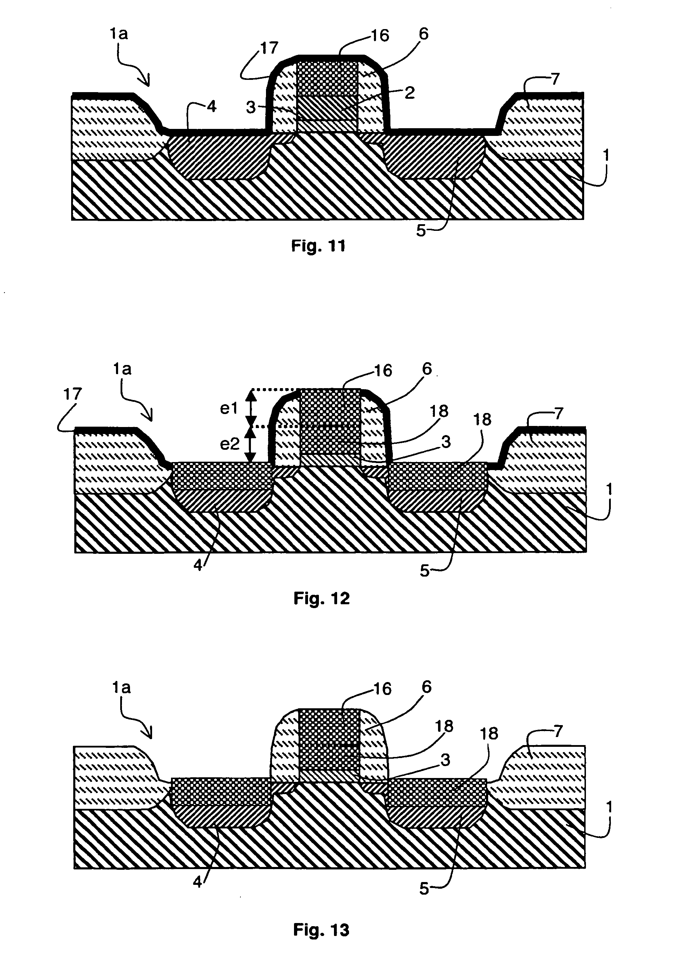

Un procédé salicide classique peut, ensuite, être avantageusement réalisé sur le substrat 1 représenté sur la figure 10, pour former, de manière non sélective, un siliciure dans la source 4, le drain 5 et la grille 2. Pour cela, une couche métallique 17 est déposée sur la surface 1a du substrat 1 (figure 11), puis un traitement thermique est réalisé de manière à former, de manière classique, une couche de siliciure 18 dans la grille 2, la source 4 et le drain 5. Le matériau constituant la couche 17 peut être identique ou non à celui constituant la couche 14. De plus, les conditions du traitement thermique sont déterminées, afin d'obtenir un siliciure d'une épaisseur e2 prédéterminée, correspondant à l'épaisseur souhaitée de siliciure dans la source 4 et le drain 5. La couche métallique 17 est, ensuite, retirée (figure 13) et un deuxième traitement thermique peut éventuellement être réalisé, comme dans l'art antérieur, pour modifier la phase du siliciure obtenu. Sur la figure 13, la grille 2 est, ainsi, totalement siliciurée et la source 4 et le drain 5 comportent chacune une couche en siliciure, suffisamment fine pour éviter les problèmes de fuites de jonction.

Les différentes étapes représentées sur les figures 6 à 10 pour le mode particulier de réalisation précédemment décrit peuvent être utilisées, d'une manière plus générale, pour réaliser un composant électronique et, notamment, pour former sélectivement, dans un substrat en matériau semi-conducteur, une zone en un composé, de préférence défini, comportant un matériau métallique et le matériau semi-conducteur constituant ledit substrat. Le composé est, ainsi, un siliciure dans le cas d'un substrat en silicium et un germaniure dans le cas d'un substrat en germanium. La formation sélective d'une telle zone est obtenue en formant préalablement :
- une couche en oxyde de germanium d'une épaisseur comprise entre 3nm et 5nm sur une partie prédéterminée d'une surface dudit substrat
- et une couche d'oxyde de silicium sur le reste de la surface.
Puis, une couche constituée par un matériau métallique choisi de manière prédéterminée est déposée sur les couches d'oxyde. Comme précédemment, le matériau métallique est avantageusement choisi non seulement en fonction du type de matériau semi-conducteur disposé sous la couche en oxyde de germanium, mais également de sorte que son oxyde soit plus stable thermodynamiquement que l'oxyde de germanium et moins stable thermodynamiquement que l'oxyde de silicium. Un recuit thermique est, ensuite, réalisé pour obtenir, au niveau de ladite partie de la surface du substrat, la réduction de l'oxyde de germanium par le matériau métallique, puis la formation du composé. La couche métallique est, ensuite, retirée.

Ainsi, le caractère sélectif et localisé de la zone formée par le composé est obtenu grâce aux deux propriétés suivantes : Dans une gamme de température donnée, le matériau métallique et le matériau semi-conducteur réagissent en présence d'oxyde de germanium tandis qu'aucune réaction n'a lieu à travers l'oxyde de silicium. En règle générale, tous les métaux dont l'oxyde est plus stable, dans une gamme de température donnée (correspondant à la gamme de température du recuit thermique) que celui du germanium et moins stable que celui du silicium peuvent être utilisés dans le cadre de l'invention. De plus, tous les matériaux semi-conducteurs sont utilisables à condition que:
- le matériau semi-conducteur puisse réagir avec le matériau métallique pour former un composé et notamment un composé défini.
- le silicium et le germanium, utilisés pour former les couches d'oxyde de silicium et d'oxyde de germanium, puissent être déposés sur le matériau semi-conducteur formant le substrat.

## Revendications

1. Procédé de fabrication d'un composant électronique qui comporte au moins une étape de formation sélective d'au moins une zone en un composé comprenant un matériau semi-conducteur et un matériau métallique (16), dans un substrat (1) en matériau semi-conducteur, ladite étape comportant au moins successivement :
- la formation d'une couche en oxyde de germanium (13), d'une épaisseur comprise entre 3nm et 5nm, sur une partie d'une surface (1 a) du substrat (1) et d'une couche en oxyde de silicium (12) sur le reste de ladite surface (1a),
- le dépôt, sur les couches d'oxyde (12, 13), d'une couche constituée par un matériau métallique, dont l'oxyde est plus stable thermodynamiquement que l'oxyde de germanium et moins stable que l'oxyde de silicium,
- le recuit thermique à une température prédéterminée pour obtenir, au niveau de ladite partie de la surface (1a) du substrat (1), la réduction de l'oxyde de germanium par ledit matériau métallique, puis la formation de ladite zone (16),
- et le retrait de la couche constituée par le matériau métallique (14).

2. Procédé selon la revendication 1, **caractérisé en ce que** le matériau semi-conducteur est choisi parmi le silicium, le germanium ou un alliage de silicium et de germanium.

3. Procédé selon l'une des revendications 1 et 2, **caractérisé en ce que** le matériau métallique est choisi parmi le chrome, le cobalt, le nickel, le cuivre, l'alliage nickel-platine et l'alliage nickel-titane.

4. Procédé selon l'une quelconque des revendications 1 à 3, **caractérisé en ce que** la température du recuit thermique est comprise entre 300°C et 800°C.

5. Procédé selon l'une quelconque des revendications 1 à 4, **caractérisé en ce qu'**un transistor comportant une grille (2), une source (4) et un drain (5) étant formé dans le substrat (1), la formation sélective de ladite zone (16) est réalisée dans la grille (2) du transistor.

6. Procédé selon la revendication 5, **caractérisé en ce que** le retrait de la couche en matériau métallique (14) est suivi d'une étape de désoxydation de la grille (2), de la source (4) et du drain (5).

7. Procédé selon la revendication 6, **caractérisé en ce que** l'étape de formation sélective de ladite zone (16) dans la grille est suivie d'une étape de formation non sélective dudit composé dans la source (4), le drain (5) et la grille (2).

## Claims

1. A method for fabricating an electronic component comprising at least one step of selective formation of at least one area made from a compound comprising a semi-conducting material and a metallic material (16) in a substrate (1) made from semi-conducting material, said step comprising at least successively:
- forming a germanium oxide layer (13) of a thickness comprised between 3nm and 5nm on a part of a surface (1a) of the substrate (1) and of a silicon oxide layer (12) on the rest of said surface (1a),
- depositing, on the oxide layers (12, 13), a layer formed by a metallic material whose oxide is thermodynamically more stable than germanium oxide and less stable than silicon oxide,
- thermal annealing at a preset temperature to obtain reduction of the germanium oxide by said metallic material followed by formation of said area (16), at the level of said part of the surface (1 a) of the substrate (1),
- and removal of the layer of metallic material (14).

2. The method according to claim 1, **characterized in that** the semi-conducting material is chosen from silicon, germanium or a silicon and germanium alloy.

3. The method according to one of claims 1 and 2, **characterized in that** the metallic material is chosen from chromium, cobalt, nickel, copper, nickel-platinum alloy and nickel-titanium alloy.

4. The method according to any one of claims 1 to 3, **characterized in that** the temperature of the thermal annealing is comprised between 300°C and 800°C.

5. The method according to any one of claims 1 to 4, **characterized in that** a transistor comprising a gate (2), source (4) and drain (5) being formed in the substrate (1), selective formation of said area (16) is performed in the gate (2) of the transistor.

6. The method according to claim 5, **characterized in that** removal of the metallic material layer (14) is followed by a step of deoxidization of the gate (2), source (4) and drain (5).

7. The method according to claim 6, **characterized in that** the step of selective formation of said area (16) in the gate is followed by a step of non-selective formation of said compound in the source (4), drain (5) and gate (2).

## Patentansprüche

1. Verfahren zur Herstellung eines elektronischen Bauteils, das mindestens einen Verfahrensschritt der selektiven Bildung mindestens einer Zone aus einer Verbindung, die einen Halbleiter-Werkstoff und einen metallischen Werkstoff (16) umfasst, auf einem Substrat (1) aus einem Halbleiter-Werkstoff aufweist, wobei dieser Verfahrensschritt aufeinander folgend mindestens
- die Bildung einer Germaniumoxid-Schicht (13) in einer Stärke von 3nm bis 5nm auf einem Teil einer Oberfläche (1a) des Substrats (1) und einer Siliziumoxidschicht (12) auf dem restlichen Teil dieser Oberfläche (1a),
- das Auftragen einer Schicht, die von einem metallischen Werkstoff gebildet wird, dessen Oxid thermodynamisch stabiler ist als das Germaniumoxid und weniger stabil als das Siliziumoxid, auf die Oxidschichten (12, 13),
- das thermische Glühen bei einer vorbestimmten Temperatur, um im Bereich des genannten Teils der Oberfläche (1a) des Substrats (1) die Reduktion des Germaniumoxids durch den genannten metallischen Werkstoff zu erhalten, und sodann die Bildung der genannten Zone (16),
- und das Schrumpfen der von dem metallischen Werkstoff (14) gebildeten Schicht
umfasst.

2. Verfahren nach Anspruch 1,
**dadurch gekennzeichnet,**
**dass** der Halbleiter-Werkstoff unter Silizium, Germanium oder einer Silizium-und Germaniumlegierung gewählt wird.

3. Verfahren nach einem der Ansprüche 1 und 2,
**dadurch gekennzeichnet,**
**dass** der metallische Werkstoff unter Chrom, Kobalt, Nickel, Kupfer, Nickel-Platin-Legierung Germanium und Nickel-Titan-Legierung gewählt wird.

4. Verfahren nach einem der Ansprüche 1 bis 3,
**dadurch gekennzeichnet,**
**dass** die Temperatur des thermischen Glühens zwischen 300 °C und 800 °C beträgt.

5. Verfahren nach einem der Ansprüche 1 bis 4,
**dadurch gekennzeichnet,**
**dass** mit einem Transistor, der ein Gate (2), eine Source (4) und einen Drain (5) aufweist und der in dem Substrat (1) gebildet ist, die selektive Bildung der genannten Zone (16) in dem Gate (2) des Transistors durchgeführt wird.

6. Verfahren nach Anspruch 5,
**dadurch gekennzeichnet,**
**dass** auf das Schrumpfen der Schicht aus metallischem Werkstoff (14) ein Verfahrensschritt des Sauerstoffentzugs des Gate (2), der Source (4) und des Drains (5) folgt.

7. Verfahren nach Anspruch 6,
**dadurch gekennzeichnet,**
**dass** auf den Verfahrensschritt der selektiven Bildung der genannten Zone (16) in dem Gate ein Verfahrensschritt der nicht selektiven Bildung dieser Verbindung in der Source (4), dem Drain (5) und dem Gate (2) folgt.
